# EUROPEAN PATENT APPLICATION

(11) **EP 3 575 920 A1**
(43) Date of publication of application: **04.12.2019**
(21) Application number: 18174761.9
(22) Date of filing: 29.05.2018
(51) Int. Cl.: G06F 1/20, H05K 7/20

(54) **A CPU COOLING MODULE FOR USE AS A DIRECT LIQUID CPU COOLING**

(71) Applicant: DCX SP. Z O.O., 20-325 Lublin (PL)
(72) Inventor: Szadkowski, Maciej, 05-500 Piaseczno (PL)
(74) Representative: Kondrat, Mariusz

(57) **Abstract**

A CPU cooling module for use as a liquid CPU cooling comprising casing and coldplate and sockets wherein coldplate additionally serves as bracket for mounting the CPU cooling module on cooled chip and having Quick Disconnect Push to Lock with Coolant supply and three Quick Disconnect Push to Lock with Coolant outlet allows user do connect tubing freely and disconnect if needed.

## Description

### BACKGROUND

The CPU Module for liquid cooling is designed to support both single-phase liquid cooling and two-phase liquid cooling. The module can be applied processors supplied by any vendor, this includes products of Intel, AMD, as well as GPU's. The design utilizes microchannels and jet impingement for liquid application onto the cooled unit.

US2017329375 describes a cooling system for a computer system comprises at least one unit such as a central processing unit (CPU) generating thermal energy and a reservoir having an amount of cooling liquid, said cooling liquid intended for accumulating and transferring of thermal energy dissipated from the processing unit to the cooling liquid. The cooling system has a heat exchanging interface for providing thermal contact between the processing unit and the cooling liquid for dissipating heat from the processing unit to the cooling liquid.
US2016377355 describes a fluid heat exchanger, which includes: a heat spreader plate including an intended heat generating component contact region; a plurality of microchannels for directing heat transfer fluid over the heat spreader plate, the plurality of microchannels each having a first end and an opposite end and each of the plurality of microchannels extending substantially parallel with each other microchannel and each of the plurality of microchannels having a continuous channel flow path between their first end and their opposite end; a fluid inlet opening for the plurality of microchannels and positioned between the microchannel first and opposite ends, a first fluid outlet opening from the plurality of microchannels at each of the microchannel first ends; and an opposite fluid outlet opening from the plurality of microchannels at each of the microchannel opposite ends, the fluid inlet opening and the first and opposite fluid outlet openings providing that any flow of heat transfer fluid that passes into the plurality of microchannels, flows along the full length of each of the plurality of microchannels in two directions outwardly from the fluid inlet opening.
From US2016146219 an electric pump is known. The pump can have a stator with a stator core defining a plurality of poles, a coil of electrically conductive material extending around each respective one of the plurality of poles, and a stator-cooling chamber, as well as an impeller coupled to a rotor. A first region can be at least partially occupied by the impeller and fluidicly coupled with the stator-cooling chamber to convey a working fluid from the first region into the stator-cooling chamber. The stator-cooling chamber can be configured to facilitate heat transfer from the stator core and/or the coils to the working fluid in the stator-cooling chamber. Cooling systems can incorporate such a pump.
DE202005003339 describes liquid cooling heat convection unit comprises housing with first chamber, liquid drive unit and cooling plate module at housing bottom. Between housing inner space and cooling plate module is second chamber, containing cooling liquid. Housing locates at least one liquid inlet and at least one liquid outlet through second chamber for circulating cooling liquid with liquid drive unit working. Periphery of cooling plate module carries fasteners to components to be cooled.
US20090044929A1 describes a liquid cooling module, which has a sealed unit and a heat dissipating module connected by multiple flexible pipes. The sealed unit has a contacting surface attached to an electronic element. The heat dissipating module has a radiator, coolant tanks and a pump all mounted compactly together. The radiator has multiple fins and tubes to allow the coolant to flow through and dissipate heat and may have a fan to increase airflow. The coolant tank is formed on the radiator. The pump circulates the coolant along the coolant pipes. Accordingly, the liquid cooling module has a compact structure and the coolant pipes are flexible, so the liquid cooling module can be mounted simply in a computer case and is installed easily by home users and professionals alike.

In the known arrangements of Direct Liquid Cooling Assembly elbows are used and connections are placed on the side, which makes it necessary to make loops bound on the modules. The device does not have quick couplers so it can be used only in one type of server and in one cabinet, there is no modular attached piping and each element is bounded as a monolith. The internal structure includes microchannels similar to the invention, but with only one phase and the other design of the chambers inside.

### BRIEF SUMMARY

The system is designed to utilize various types of coolant - dielectric fluids, proprietary water/glycol-based coolant, or any other substance liquids. The liquids can contain various additives and inhibitors. The end user can choose what liquid to use and to make safety decisions individually, based on the availability of a given coolant in his location. It utilises a dual-phase heat dissipation and features a system for separation of the two phases. Because of this, the pressure in the system is lower, while the heat transfer is optimised. Additionally, thanks to a parallel pipe routing room within a rack and in the area around it is optimised.

The system utilises push-in (push to clock) fittings, which allows the end-user to produce his own liquid cooling loops, without the need of designing specific installation per each server/device and rack withing the device is installed.

The hexagonal chamber of the cooling block allows maintaining of a proper pressure of liquid leaving the split line jets, no matter the coolant used. Additionally, the coldplate features a triple-split construct of microchanels, giving ability to utilise and an angled arrangement of the jets, which are set up in a manner to match the dynamics of a mix of vapour and liquid as the share of vapour in the mix increases. The block also uses a solid-copper plate which is used as a heat exchanger. The cooling module block has only 21 mm in height thus making the block easy to mount even on extremely compact 1U low-profile blade architectures.

The components of the cooling block consist of:
- POM-based casing, which features all of the connection sockets
- a copper or aluminium coldplate with microchannels serving also as mounting bracket
- a set of sockets and screws with springs designed for attachment of the coldplate on the unit to be cooled
- The CPU cooling module has been designed to allow the end user the customisation of the system. It therefore uses push-in connectors and sockets (Push To Lock ports) which give the ability to connect and disconnect the tubing. That allows for configuration of cooling loop for any type of device on which this CPU cooling module is installed, and then reconfiguration of cooling loop in other device. The block can be installed on systems sold by various vendors
- The CPU cooling module It allows the use of two types of jets - split-line jets and hex jets, as well as various coolant liquids and heat exchange processes (dual-phase or single-phase).
- The system also allows the user to make a decision concerning the type of piping - with customisable length and type (notched or smooth, etc).
- The block can be used in case of any CPUs available in the market as dimensions of casing and coldplate may be changed to CPU model and CPU socket.

A CPU cooling module for use as a liquid CPU cooling comprising casing, and coldplate and sockets. Coldplate additionally serves as bracket for mounting the CPU cooling module on cooled chip and having one Quick Disconnect Push to Lock with Coolant supply and three Quick Disconnect Push to Lock with Coolant outlet allows user do connect tubing freely and disconnect if needed to reconfigure and adapt cooling loop for specific device and rack.
The CPU cooling module has Quick Disconnect Push to Lock with Coolant supply and Quick Disconnect Push to Lock with Coolant outlet are arranged in the way that it gives possibility to connect two or more CPU cooling modules in linear, streamlined connection, without use of elbows and joints to connect tubing, which does not require to accommodate large loops and special corrugated tubing that must be used to so the tubing will not break or cut the flow of coolant.
The CPU cooling module is working in dual phase option or negative pressure option.
The CPU cooling module has the casing consists of two separate chambers and features a coolant supply port and three fluid outlet ports.
The CPU cooling module has casing of cooling module, which has vortex chamber, which is cylindrical and funnel shaped to even-out the pressure for jet line, which are used to inject the coolant liquid into the coldplate with Triple - Split Microchannels.
The CPU cooling module has casing closed from the bottom with three split micro-channels coldplate, which is solid copper or aluminium component of the CPU cooling module, which has the 3-Split-Flow microchannel construct that provides minimize pressure drop, maximises coolant flow and separates coolant fractions, which additionally serves as bracket for mounting the CPU cooling module on cooled chip.
The casing is made with polixylomethylene.
The coldplate has microchannels.

### BRIEF DESCRIPTION OF THE DRAWINGS

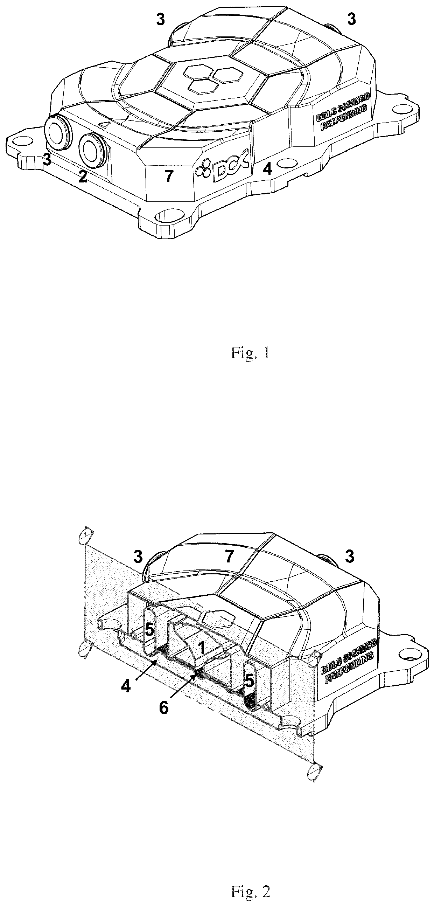

Fig. 1 depicts one embodiment of an example cooling block.
Fig. 2 depicts one embodiment of Vortex chamber.

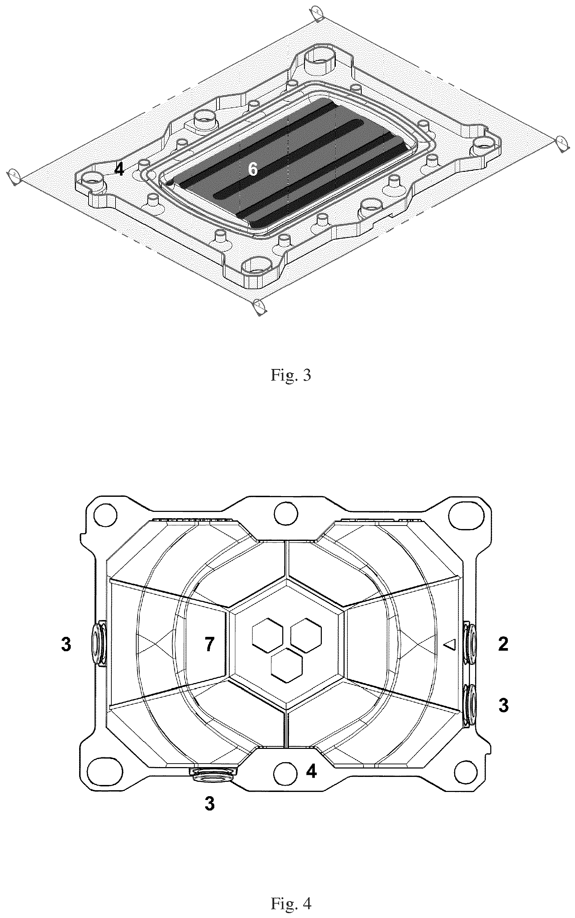

Fig. 3 depicts one embodiment of Triple-split microchannel heatsinks
Fig. 4 depicts one embodiment of location of push - in fittings (Push To Lock ports)

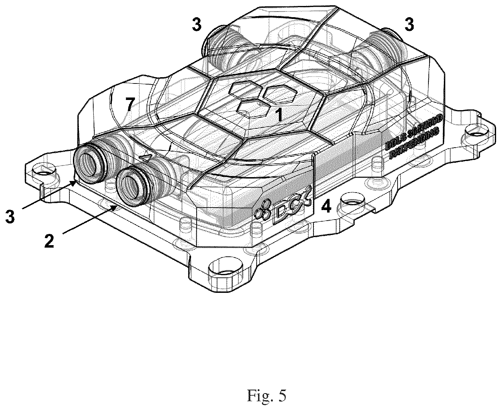

Fig. 5 depicts one embodiment of an example cooling block with internal components.

### DETAILED DESCRIPTION

### Cooling block design

The CPU cooling module for liquid cooling is designed to support both single-phase liquid cooling and two-phase liquid cooling. The module can be applied processors supplied by any vendor, this includes products of Intel, AMD, as well as GPU cards. The design utilises microchannels and jet impingement for efficient heat pickup rom cooled chip by the means of liquid traveling inside the CPU cooling module.

### Casing

The casing is made with polixylomethylene. It is attached to a cold plate with 12 screws. The casing consists of two separate chambers.
The upper 'vortex' chamber has longitudinal arranged jet which are used to inject the coolant liquid into the lower chamber. The chamber is designed in lengthwise, extended cylindrical shape, that is formed vertically in conformation of funnel, to even-out the pressure for each place within the jet. The casing features a one coolant supply socket and 3 fluid outlets. The supply and outflows are located in front, rear and left side of casing to allow straight, not angled connection of tubing, which allows the cooling loop to be arranged in various manners without pressure constraining 90 degrees elbow joints or use of bight of connected tubing. The upper chamber within the casing is connected directly to the supply. The bottom section of the upper chamber has jet arranged so that it impinges flow of pressurised coolant onto the heat sink.
The lower chamber's function is to allow outflow of the liquid trough one of the push in fitting outflowed port chosen by the user. Its outer section is arranged to optimise the flow of liquid and separation of the two phases. The chamber is sealed at the bottom with a metal (copper, or aluminium) coldplate with microchannels.

The CPU cooling module having casing of cooling module (7), which has vortex chamber (1), which is cylindrical and funnel shaped to even-out the pressure for jet line, which are used to inject the coolant liquid into the coldplate with Triple - Split Microchannels (4). This arrangement directs the coolest liquid to the hottest area of the processor first with even pressure.
The CPU cooling module has Quick Disconnect Push to Lock supply and outlet Ports (2 and 3) allows user do connect tubing freely and disconnect if needed. CPU cooling modules can be reused in different servers and different racks as opposed to all other systems where all joints are connected, glued and preassembled in factory so specific loop fits only one specific server, installed in one specific rack, because all tubes length are scaled to specific distances between modules and liquid distribution device - manifold. In fore mentioned CPU cooling module User is able to create alone his required loop and install on any server they would prefer and is not tied to specific server brand or rack as required in other types on direct liquid cooling components.
In DDLC LGA 3647 module enclosure has one supply and 3 outlet ports, providing in line, streamlined connection between modules and flexibility for enduser to configure loop. That provides less pressure drop.
The CPU cooling module can work in Dual phase option: user can choose between dielectric engineered fluids or proprietary water / glycol based coolant. So, either availability of water & glycol based coolants or best efficiency that you can get only from dual phase heat pickup with separation of phases.
The CPU cooling module can work inNegative pressure option : CPU direct liquid cooling module may work with pressure vacuum based system that in difference to positive pressure systems guarantees maximum safety as in unlikely event of losing the integrity of cooling loop, all fluid is evacuated from the loop by vacuum negative pressure, thus giving complete safety, also in reconfiguration of the loop.

### Coldplate

The coldplate has microchannels that cover most of the heatsink. The design uses triple-split microchannel heatsinks. The 3-Split-Flow design uses adaptive microchannel architecture to minimize pressure drop, maximise coolant flow, separate coolant fractions and direct the coolest liquid to the hottest area of the processor first.

### Sockets

The sockets are arranged in a manner that allows the block to be connected in a daisy chain without the need of applying side elbow joints. Moreover, this design allows the pipes to be connected more easily in dense server configuration, and to be routed over the components of the devices cooled.

### Modular bracket

The modular bracket allows adaptation of the block to fit various designs of the cooled components. The design allows the block to be mounted on the coldplate in a stable manner.

### Example 1 Fluid Flow:

Warm cooling fluid - typically based on water with additives (e. g. glycol and several inhibitors) flows through supply 2 push to lock quick disconnect port to upper chamber 1 (vorthex chamber).

Vortex chamber is cylindrical in shape, but internal build resembles funnel. Warm coolant fluid revolves on top chamber walls and dissipates to shape of split line 6 (Jetsplit).

Fluid gathers additional velocity when going through constricting walls of chamber 1.

Fluid is pushed though jestsplit 6 to three split microchannel coldplate 4.

Fluid travels through microchannels to outflow chamber 5. The outflow chamber 5 is sealed at the bottom with a coldplate. Fluid can be then removed by positive or negative pressure through one of Outlet Quick Disconnect Push to Lock Ports 3 that end user will choose.

### Description:

1. (Upper) Vortex Chamber
2. Quick Disconnect Push to Lock Port with Coolant Supply
3. Quick Disconnect Push to Lock Port with Coolant Outlet
4. Coldplate with Triple - Split Microchannels
5. (Lower) Outflow Chamber
6. Jetsplit
7. Casing

### Features and differences from existing solutions:

As opposite to existing liquid cooling components device provides distinctive features not available in other type of cooling devices:
1. IN LINE CONNECTION In all other offerings cooling modules use different type of elbows and joints to connect tubing, and when 2 or 4 processors are used, it is not possible to route tubing without using 90* elbow joints or large loops that must be used to so the tubing will not break or cut the flow od coolant. In DDLC LGA 3647 module enclosure has one supply and 3 outlet ports, providing in line, streamlined connection between modules and flexibility for end user to configure loop. That provides less pressure drop.
2. PTL* (*push to lock) QUICK DISCONNECTS eg. Push - in fittings. In all other systems all joints are connected, glued and preassembled in factory so specific loop fits only one specific server, installed in one specific rack because all tubes length are scaled to specific distances between modules and liquid distribution device - manifold. In DCX solution usage of push to lock quick disconnects allows user do connect tubing freely and disconnect if needed. So, modules can be reused in different servers and different racks, and replacement of tubing is easy as self assembly of popular furniture brand. User is able to create alone his required loop and install on any server they would prefer and is not tied to specific server brand or rack as required in other types on direct liquid cooling components.
3. Three split micro-channels coldplate - solid copper component of DDCX module, which delivers superior performance for today's high thermal density processors. The 3-Split-Flow design uses adaptive microchannel architecture to minimize pressure drop, maximise coolant flow, and direct the coolest liquid to the hottest area of the processor first.
4. Vortex chamber technology - upper chamber has cylindrical and cone / funnel shape. That provides best available flow without constrictions allows to get best efficiency from jet channels.
5. Jet splitline or hexajet technology - there is no universal solution for everything, so we are using 2 jet layouts depending on chosen coolant - jet line for single phase fluids, or hexajet design for dual phase applications, where jets are in cell / hexagonal structure, so we can get most from jet impingement.
   for dual phase fluids - adaptive channels technology with usage of stellated channels - from micro to mini-channels. Channels are adapting for fluid & as mixture dynamics, so they can direct engineered fluid flow and get the best from evaporating solution.
6. Dual phase option: user can choose between dielectric engineered fluids or proprietary water / glycol based coolant. So, either availability of water & glycol based coolants or best efficiency that you can get only from dual phase heat pickup with separation of phases.
7. Negative pressure option: CPU direct liquid cooling module may work with pressure vacuum based system that in difference to positive pressure systems guarantees maximum safety as in unlikely event of losing the integrity of cooling loop, all fluid is evacuated from the loop by vacuum negative pressure, thus giving complete safety, also in reconfiguration of the loop.

## Claims

1. A CPU cooling module for use as a direct liquid CPU cooling comprising casing (7), and coldplate and sockets wherein coldplate (4) additionally serves as bracket for mounting the CPU cooling module on cooled chip and having one Quick Disconnect Push to Lock with Coolant supply (2) and three Quick Disconnect Push to Lock with Coolant outlet (3) allows user do connect tubing freely and disconnect if needed to reconfigure and adapt cooling loop for specific device and rack.

2. The CPU cooling module according to claim 1, wherein Quick Disconnect Push to Lock with Coolant supply (2) and Quick Disconnect Push to Lock with Coolant outlet (3) are arranged in the way that it gives possibility to connect two or more CPU cooling modules in linear, streamlined connection, without use of elbows and joints to connect tubing, which does not require to accommodate large loops and special corrugated tubing that must be used to so the tubing will not break or cut the flow of coolant.

3. The CPU cooling module according to claim 1, wherein CPU cooling module is working in dual phase option or negative pressure option.

4. The CPU cooling module according to claim 1, having the casing consists of two separate chambers and features a coolant supply port and three fluid outlet ports.

5. The CPU cooling module according to claim 1 or 2, having casing of cooling module (7), which has vortex chamber (1), which is cylindrical and funnel shaped to even-out the pressure for jet line, which are used to inject the coolant liquid into the coldplate with Triple - Split Microchannels (4).

6. The CPU cooling module according to claim 1, having casing (7) closed from the bottom with three split micro-channels coldplate (4), which is solid copper or aluminium component of the CPU cooling module, which has the 3-Split-Flow microchannel construct that provides minimize pressure drop, maximises coolant flow and separates coolant fractions, which additionally serves as bracket for mounting the CPU cooling module on cooled chip.

7. The CPU cooling module according to claim 1, wherein the casing is made with polixylomethylene.

8. The CPU cooling module according to claim 1, wherein the coldplate has microchannels.
